(19) Europäisches Patentamt
European Patent Office
Office européen des brevets

(11) **EP 2 344 900 B1**

(12) **FASCICULE DE BREVET EUROPEEN**

(45) Date de publication et mention
de la délivrance du brevet:
**18.07.2018 Bulletin 2018/29**

(21) Numéro de dépôt: **09744343.6**

(22) Date de dépôt: **28.10.2009**

(51) Int Cl.:
***G01R 31/36*** *(2006.01)*

(86) Numéro de dépôt international:
**PCT/EP2009/007732**

(87) Numéro de publication internationale:
**WO 2010/049148 (06.05.2010 Gazette 2010/18)**

(54) **PROCEDE DE DETERMINATION DE L'ETAT DE CHARGE D'UNE BATTERIE EN PHASE DE CHARGE OU DE DECHARGE**

VERFAHREN ZUR BESTIMMUNG DES LADUNGSZUSTANDS EINER BATTERIE IN EINER LADE- UND ENTLADEPHASE

METHOD FOR DETERMINING THE CHARGING STATE OF A BATTERY IN A CHARGING OR DISCHARGING PHASE

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **30.10.2008 FR 0806045**

(43) Date de publication de la demande:
**20.07.2011 Bulletin 2011/29**

(73) Titulaires:
• **Commissariat à l'Energie Atomique**
  **75015 Paris (FR)**
• **Institut Polytechnique de Grenoble**
  **38031 Grenoble Cedex 1 (FR)**

(72) Inventeurs:
• **MINGANT, Rémy**
  **F-29870 Lannilis (FR)**
• **LEFROU, Christine**
  **F-38000 Grenoble (FR)**
• **REYNIER, Yvan**
  **F-38000 Grenoble (FR)**

(74) Mandataire: **Gris, Sébastien**
  **Cabinet Hecké**
  **Europole**
  **10, rue d'Arménie - BP 1537**
  **38025 Grenoble Cedex 1 (FR)**

(56) Documents cités:
**EP-A- 0 391 106       EP-A- 1 589 346**
**EP-A2- 1 901 413      WO-A1-2008/082010**
**DE-A1- 10 203 810     US-A1- 2005 231 206**

## Description

### Domaine technique de l'invention

L'invention est relative à un procédé de détermination de l'état de charge d'une batterie pendant une phase de charge ou de décharge de la batterie.

### État de la technique

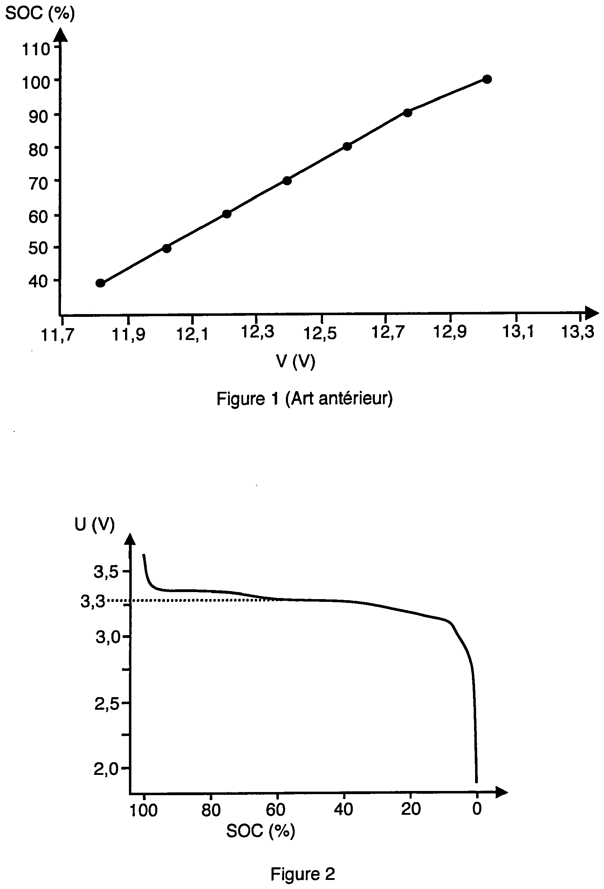

Dans les batteries au plomb, l'état de charge (SOC) varie, classiquement, en fonction de la tension de la batterie en circuit ouvert (courant nul) dans une large gamme, par exemple de plus de un Volt d'amplitude comme illustré à la figure 1 (article « Methods for state-of-charge determination and their applications » de Sabine Piller et al. publié en 2001 dans le « journal of power sources » pages 113 à 120). L'état de charge de ces batteries peut alors être déterminé par une simple mesure de potentiel dont la précision dépend de la précision de la mesure de la tension ainsi que de la pente de la courbe de décharge de la batterie en fonction de son état de charge.

L'état de charge peut également être déterminé à partir de la mesure de la tension à courant non nul. La précision dépend alors de la précision de la mesure de tension, mais aussi du courant, de la pente de la courbe caractéristique de la décharge de la batterie en fonction de son état de charge, ainsi que des paramètres d'estimation de la tension de batterie à courant non nul.

Ces méthodes par interpolation du potentiel ne sont pas adaptées à certaines batteries actuelles, en particulier les batteries de type lithium-ion à cathode en matériau biphasique, dans lesquelles la différence de tension entre l'état chargé et l'état déchargé est faible. En effet, comme illustré à la figure 2, les variations de la tension U en volts de la batterie en fonction de l'état de charge (SOC) sont tellement faibles que pour une tension de 3,3V, il est impossible de savoir si l'état de charge est plus proche de 40% que de 60%.

De manière connue, l'état de charge d'une batterie peut également être déterminé par intégration du courant en fonction du temps. La précision d'une estimation utilisant cette méthode dépend de la précision de la mesure du courant. Il est également nécessaire de connaître la capacité initiale de l'élément, la capacité de charge totale, le rendement faradique. Un des principaux défauts de cette technologie est l'accumulation des erreurs cycles après cycles, induisant des incertitudes de plus en plus importantes (dépendantes des estimations de capacité initiales de l'élément et de sa capacité totale). Cette technique n'est donc pas applicable pour une gestion à long terme d'une batterie.

Le document EP0391106 décrit une méthode de détermination de l'état de charge d'une batterie au plomb pouvant être connectée à diverses charges. Une courbe de référence connue représentative de la tension d'une cellule en fonction de l'état de charge SOC en circuit ouvert est utilisée. Pour un état de charge donnée, une tension est mesurée en circuit ouvert qui est supérieure à la valeur proposée par la courbe de référence. Après cette mesure, la batterie est placée en phase de décharge et une tension est mesurée immédiatement. La variation de tension permet de déterminer une valeur qui est appliquée à la courbe de référence pour obtenir d'autres courbes de référence associées à la décharge pour différentes valeurs de charges connectées.

Le document US2005/231206 divulgue les caractéristiques du préambule de la revendication 1.

### Objet de l'invention

L'objet de l'invention a pour but un procédé de détermination de l'état de charge précis et facile à mettre en oeuvre.

Ce but est atteint par le fait que le procédé comporte au cours de ladite phase, les étapes successives suivantes :

- la mesure d'un paramètre électrique de la batterie,
- la mise en circuit ouvert de la batterie pendant une période de repos,
- la mesure d'au moins des première et seconde valeurs de la tension aux bornes de la batterie à des instants différents au cours la période de repos,
- la détermination d'un indicateur en fonction dudit paramètre électrique et des valeurs de la tension mesurées pendant la période de repos,

et la détermination de l'état de charge correspondant à l'indicateur au moyen d'une courbe d'étalonnage représentative des variations de l'indicateur en fonction de l'état de charge pendant la phase de charge ou de décharge.

Le paramètre électrique mesuré est soit le courant I traversant la batterie avant sa mise en circuit ouvert soit la tension $U_{(t0)}$ aux bornes de la batterie avant sa mise en circuit ouvert.

Selon une première variante, utilisant comme paramètre la tension $U_{(t0)}$ aux bornes de la batterie, l'indicateur ind1 est donné par la formule

$$ind1 = \frac{U_{(t2)} - \alpha}{U_{(t2)} - U_{(t1)}} \times (U_{(t1)} - U_{(t0)})$$ avec $U_{(t1)}$ la

première mesure de tension pendant la période de repos, $U_{(t2)}$ la seconde mesure de tension pendant la période de repos et $\alpha$ un paramètre déterminé au préalable pendant une phase d'étalonnage par itérations successives de $\alpha$, pour obtenir une courbe d'étalonnage monotone.

Selon une seconde variante, utilisant comme paramètre le courant I, l'indicateur est donné par la formule $$ind2 = \frac{U_{(t2)} - \alpha}{U_{(t2)} - U_{(t1)}} \times I$$ avec $U_{(t1)}$ la première

valeur de tension mesurée pendant la période de repos,

$U_{(t2)}$ la seconde valeur de tension mesurée pendant la période de repos et α un paramètre déterminé au préalable pendant une phase d'étalonnage par itérations successives de a, pour obtenir une courbe d'étalonnage monotone.

**Description sommaire des dessins**

D'autres avantages et caractéristiques ressortiront plus clairement de la description qui va suivre de modes particuliers de réalisation de l'invention donnés à titre d'exemples non limitatifs et représentés aux dessins annexés, dans lesquels :

La figure 1 représente une courbe de détermination de l'état de charge d'une batterie par l'intermédiaire d'une mesure de tension à circuit ouvert, selon l'art antérieur.
La figure 2 illustre la variation de la tension en circuit ouvert en fonction de l'état de charge d'une batterie lithium-ion.
La figure 3 représente l'évolution de la tension de la batterie en fonction du temps au cours d'une phase de décharge pendant une phase de détermination de l'état de charge de la batterie selon l'invention.
La figure 4 illustre une courbe d'étalonnage représentative de l'indicateur déterminé après la période de repos en fonction de l'état de charge.
La figure 5 illustre différentes courbes, associées chacune à un α différent, représentatives de l'évolution des valeurs de l'indicateur en fonction de l'état de charge.

**Description de modes de réalisation particuliers**

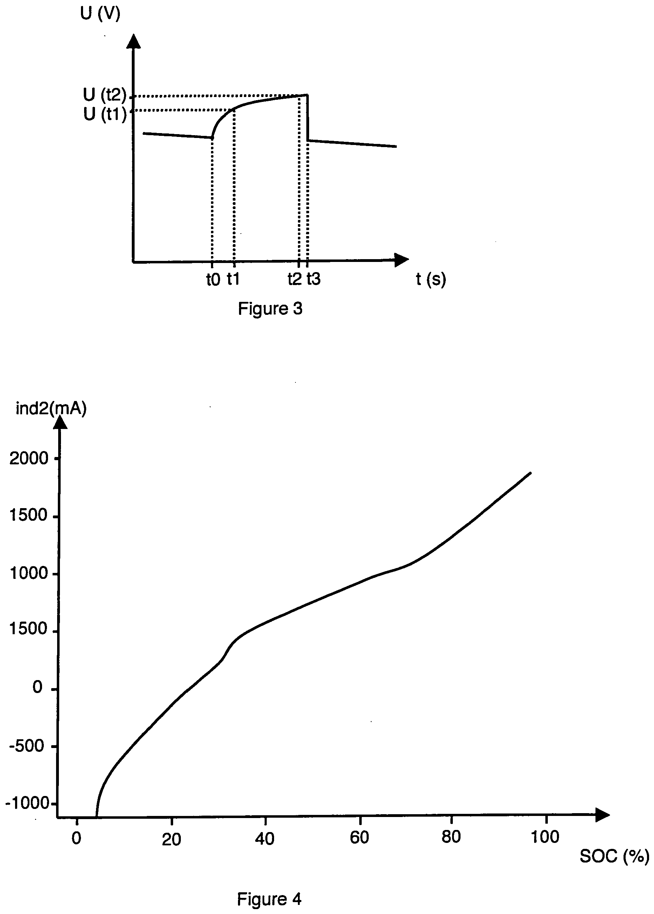

Comme illustré à la figure 3, pour déterminer l'état de charge de la batterie ou d'un accumulateur durant une phase de charge ou de décharge, la figure 3 représente l'évolution de la tension de la batterie en fonction du temps pour une phase de décharge avec une étape de détermination de l'état de charge. On mesure tout d'abord un paramètre électrique de la batterie avant de mettre la batterie au repos entre les instants t0 et t3. La mise au repos de la batterie correspond à une mise en circuit ouvert, ainsi aucun courant ne traverse la batterie. Cette mise au repos provoque une variation de la tension aux bornes de la batterie. Typiquement, cette variation correspond à une augmentation de la tension si la batterie est en phase de décharge (figure 3) ou à une diminution de la tension si la batterie est en phase de charge (non représentée). La période de repos (t0-t3) est, de préférence, inférieure ou égale à 60 secondes, durée au cours de laquelle la tension atteint généralement la tension de plateau.

Au cours de la période de repos (t0-t3), les valeurs de la tension aux bornes de la batterie sont mesurées à au moins deux instants différents t1 et t2. L'instant t2 peut être égal à l'instant t3, c'est-à-dire que la tension est mesurée juste avant de reprendre la phase de charge ou de décharge de la batterie. Un indicateur est ensuite déterminé à partir de la mesure du paramètre électrique et des valeurs de la tension $U_{(t1)}$ et $U_{(t2)}$ mesurées pendant la période de repos t0-t3.

L'indicateur peut être obtenu de deux manières différentes soit par mesure du courant soit par mesure de la tension en tant que paramètre électrique.

Selon une première variante, le paramètre électrique mesuré est la tension U aux bornes de la batterie avant la période de repos, c'est-à-dire à t0. Après la mesure, au cours de la période de repos, d'au moins deux valeurs de la tension aux instants t1 et t2, il est possible de déterminer l'indicateur en appliquant la formule :

$$ind1 = \frac{U_{(t2)} - \alpha}{U_{(t2)} - U_{(t1)}} \times (U_{(t1)} - U_{(t0)})$$

où $U_{(t1)}$ et $U_{(t2)}$ représentent les tensions mesurées respectivement aux instants t1 et t2,
α est un paramètre dépendant de la charge ou de la décharge de la batterie.

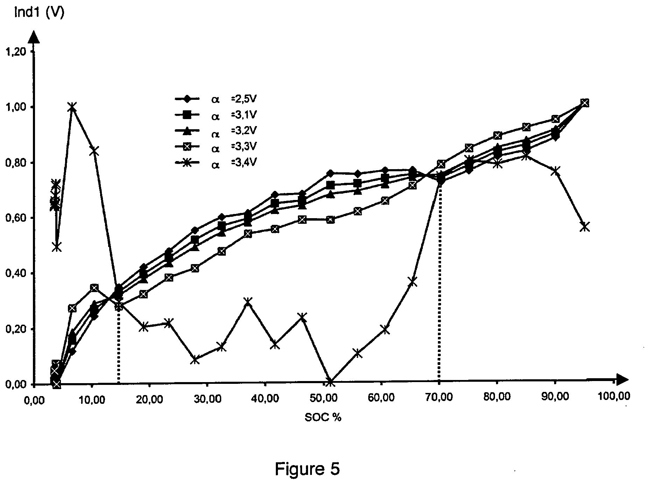

Le paramètre α dépend du type de la batterie. Il est déterminé au préalable au cours d'une phase d'étalonnage par itérations successives de valeurs possibles de a, par exemple, entre 0V et la tension nominale de la batterie, pour obtenir une courbe d'étalonnage monotone représentative de l'indicateur en fonction de l'état de charge. La figure 5 représente le comportement de l'évolution des valeurs de l'indicateur en fonction de l'état de charge (SOC) pour des valeurs de α respectivement de 2,5V, 3,1V, 3,2V, 3,3V, et 3,4V pour une phase décharge de 10 heures d'une batterie de type $LiFePO_4/LiC_6$ de format 18650 et de capacité 1.4Ah. La courbe associée à la valeur de α = 3,2V est la plus monotone, c'est-à-dire qu'elle ne présente pas de rupture de pente ni d'inversion de la pente. Au contraire, les courbes associées à α = 2,5V et α =3,1V présentent une rupture et une inversion de pente au niveau d'un état de charge de 70%. De même, la courbe associée à la valeur de α = 3,4V, présente un grand nombre de ruptures de pentes. En ce qui concerne la courbe associée à α = 3,3V une rupture est obtenue pour un état de charge de 15%. Les courbes ne présentant pas de monotonie ne sont pas satisfaisantes car dans ce cas, pour un même indicateur, il peut exister une pluralité de valeurs d'état de charge correspondantes. Pour une batterie du type testé à la figure 5, la valeur de α à retenir est donc 3.2V.

Bien que dans l'exemple ci-dessus α soit déterminé par itérations successives au cours de la phase d'étalonnage, il est à noter que sa valeur est proche du potentiel moyen en charge ou en décharge de la batterie lorsque les batteries testées ont des électrodes comportant les matériaux suivants $LiFePO_4/Graphite$ ou $LiFePO_4/Li_4Ti_5O_{12}$. Pour $LiFePO_4/Li_4Ti_5O_{12}$, le α correspondant vaut 1,8V. Le potentiel moyen se définit par le rapport entre l'énergie de la batterie (en W.h) et la capacité de la batterie (en A.h) pour un régime donné de charge ou de décharge.

Selon la seconde variante, le paramètre électrique mesuré est le courant I passant dans la batterie avant la période de repos, c'est-à-dire à t0. Après la mesure du courant I, la batterie est placée en période de repos durant laquelle sont mesurées au moins deux valeurs de la tension respectivement aux instants t1 et t2. Il est ensuite possible de déterminer l'indicateur ind2 en appliquant la formule :

$$ind2 = \frac{U_{(t2)} - \alpha}{U_{(t2)} - U_{(t1)}} \times I$$

où $U_{(t1)}$ et $U_{(t2)}$ représentent les tensions mesurées respectivement aux instants t1 et t2,
$\alpha$ est un paramètre dépendant de la charge ou de la décharge de la batterie, déterminé de manière similaire à la variante décrite ci-dessus pour obtenir une courbe d'étalonnage monotone.

L'indicateur est ensuite utilisé pour déterminer l'état de charge (SOC) de la batterie à partir de la courbe d'étalonnage (figure 4) obtenue au préalable à partir d'au moins une batterie étalon, cette courbe est représentative des variations de l'indicateur en fonction de l'état de charge de la batterie pendant la phase de charge ou de décharge. De préférence, la courbe d'étalonnage fournit la relation entre l'indicateur et l'état de charge de la batterie pour un $\alpha$ prédéterminé. De préférence, la courbe d'étalonnage utilisée est celle qui a permis de déterminer le meilleur a. La courbe de la figure 4 représente la courbe d'étalonnage correspondant à la variante où l'on mesure comme paramètre électrique l'intensité (ind2) traversant la batterie. Il est nécessaire de réaliser deux courbes d'étalonnage, en effet, les courbes d'étalonnage sont différentes s'il s'agit d'une phase de charge ou de décharge de la batterie. Comme l'illustre la figure 4, la courbe d'étalonnage représente l'évolution de l'indicateur ind2 en fonction de l'état de charge de la batterie au cours d'une phase de décharge. Cette courbe a été obtenue lors de la phase d'étalonnage par itérations successives de $\alpha$ déjà précédemment décrite. Des tests réalisés sur trois batteries étalon de marque identique ont démontré une faible dispersion des résultats permettant d'obtenir une reproductibilité importante de la mesure avec un écart-type inférieur à 5%.

Ainsi, selon un exemple de réalisation, pour une pile de type LiFePO$_4$/LiC$_6$ cylindrique de format 18650 et de capacité 1,4Ah en phase de décharge et pour une période de repos de durée 30 secondes et avec t2 = t3, le calcul de ind2 donne :

$$ind2 = \frac{U_{(30s)} - 3,2}{U_{(30s)} - U_{(1s)}} \times I$$

avec U(30s) = 3,25V, U(1s) = 3,21V et I = 0,07 A pour une phase de décharge de 20 heures de la batterie. On obtient ainsi une valeur de ind2 de 0,0875A.

Par lecture de la courbe de la figure 4, on obtient une valeur d'estimation de l'état de charge (SOC) de 25%.

Ce même calcul réalisé pour une seconde mesure de tension à t2 = 1s au lieu de t2 = 30s montre également une bonne monotonie de la courbe d'étalonnage, avec un écart-type inférieur à 20% de l'état de charge.

Le procédé selon l'invention est adapté à la chimie de la batterie, il permet notamment de déterminer l'état de charge d'une batterie ayant comme couple d'électrodes soit une électrode en matériau biphasique soit les deux. Le procédé est plus particulièrement adapté aux batteries comportant en matériaux d'électrode LiFePO$_4$ et Li$_4$Ti$_5$O$_{12}$. L'établissement de l'état de charge de telles batteries est réalisé avec une importante précision dont l'incertitude est inférieure à 10%, alors qu'elle est supérieure à 15% avec les méthodes de l'art antérieur. Il n'est pas non plus nécessaire d'intégrer une mémoire et un circuit effectuant des corrections en fonction des données relatives aux charges et décharges précédentes de la batterie.

Ce procédé particulièrement intéressant peut être appliqué dans le domaine photovoltaïque. Il peut aussi être appliqué dans le domaine des appareils mobiles, comme les téléphones et les ordinateurs ou encore dans le domaine des véhicules hybrides et électriques où il est critique d'utiliser des jauges de charge précises.

**Revendications**

1. Procédé de détermination de l'état de charge d'une batterie pendant une phase de charge ou de décharge de la batterie, comportant au cours de ladite phase, les étapes successives suivantes :

   - la mesure d'un courant I traversant la batterie avant sa mise en circuit ouvert,
   - la mise en circuit ouvert de la batterie pendant une période de repos (t0-t3),
   - la mesure d'au moins des première et seconde valeurs de la tension aux bornes de la batterie à des instants (t1, t2) différents au cours la période de repos (t0-t3),
   - la détermination d'un indicateur (ind2) en fonction dudit courant I et des valeurs de la tension mesurées pendant la période de repos,
   - et la détermination de l'état de charge correspondant à l'indicateur au moyen d'une courbe d'étalonnage représentative des variations de l'indicateur en fonction de l'état de charge pendant la phase de charge ou de décharge,

   procédé **caractérisé en ce que** l'indicateur est don-

né par la formule $ind2 = \dfrac{U_{(t2)} - \alpha}{U_{(t2)} - U_{(t1)}} \times I$ avec

U(t1) la première valeur de tension mesurée pendant la période de repos, U(t2) la seconde valeur de tension mesurée pendant la période de repos et α un paramètre déterminé au préalable pendant une phase d'étalonnage par itérations successives de a, pour obtenir une courbe d'étalonnage monotone.

**2.** Procédé de détermination de l'état de charge d'une batterie pendant une phase de charge ou de décharge de la batterie, comportant au cours de ladite phase, les étapes successives suivantes :

- la mesure d'une tension U(t0) aux bornes de la batterie avant sa mise en circuit ouvert,
- la mise en circuit ouvert de la batterie pendant une période de repos (t0-t3),
- la mesure d'au moins des première et seconde valeurs de la tension aux bornes de la batterie à des instants (t1, t2) différents au cours la période de repos (t0-t3),
- la détermination d'un indicateur (ind1) en fonction de ladite tension U(t0) et des valeurs de la tension mesurées pendant la période de repos,
- et la détermination de l'état de charge correspondant à l'indicateur au moyen d'une courbe d'étalonnage représentative des variations de l'indicateur en fonction de l'état de charge pendant la phase de charge ou de décharge

procédé **caractérisé en ce que** l'indicateur est donné par la formule

$$ind1 = \frac{U_{(t2)} - \alpha}{U_{(t2)} - U_{(t1)}} \times (U_{(t1)} - U_{(t0)})$$ avec U(t1)

la première mesure de tension pendant la période de repos, U(t2) la seconde mesure de tension pendant la période de repos et α un paramètre déterminé au préalable pendant une phase d'étalonnage par itérations successives de α, pour obtenir une courbe d'étalonnage monotone.

**3.** Procédé selon l'une des revendications 1 et 2, **caractérisé en ce que** la période de repos a une durée inférieure ou égale à 60 secondes.

**Patentansprüche**

**1.** Verfahren zur Bestimmung des Ladungszustands einer Batterie während einer Lade- oder Entladungsphase der Batterie, welches im Verlauf dieser Phase die folgenden aufeinander folgenden Verfahrensschritte umfasst:

- die Messung eines Stromflusses I durch die Batterie vor deren Anschluß an einen offenen Stromkreis,
- Anschluß der Batterie an einen offenen Stromkreis während einer Ruhezeit (t0 - t3),
- die Messung wenigstens eines ersten und eines zweiten Spannungswerts an den Batterieklemmen zu verschiedenen Zeitpunkten (t1, t2) während der Ruhezeit (t0 - t3),
- die Bestimmung eines Indikators (ind2) in Abhängigkeit von dem genannten Stromfluss I und den während der Ruhezeit gemessenen Spannungswerten, und
- die Bestimmung des Ladungszustands entsprechend dem Indikator mittels einer Eichungskurve, die Schwankungen des Indikators in Abhängigkeit vom Ladungszustand während der Lade- oder Entladungsphase darstellt,

**dadurch gekennzeichnet,**
**dass** der Indikator durch die Formel

$$ind2 = \frac{U_{(t2)} - \alpha}{U_{(t2)} - U_{(t1)}} \times I$$

gegeben ist, wobei U(l1) der erste in der Ruhezeit gemessene Spannungswert ist, U(l2) der zweite in der Ruhezeit gemessene Spannungswert ist und α ein Parameter, der vorab während einer Eichungsphase von α in aufeinander folgenden Wiederholungen bestimmt wird, um eine gleichförmige Eichungskurve zu erhalten.

**2.** Verfahren zur Bestimmung des Ladungszustands einer Batterie während einer Lade- oder Entladephase der Batterie, welches im Verlauf dieser Phase die folgenden aufeinander folgenden Verfahrensschritte umfasst:

- Messen einer Spannung U(l0) an den Klemmen der Batterie vor deren Anschluß an einen offenen Stromkreis,
- Anschluß der Batterie an einen offenen Stromkreis während einer Ruhezeit (t0 - t3),
- die Messung wenigstens eines ersten und eines zweiten Werts der Spannung an den Batterieklemmen zu verschiedenen Zeitpunkten (t1, t2) während der Ruhezeit (t0 - t3),
- die Bestimmung eines Indikators (ind1) in Abhängigkeit von der genannten Spannung U(l0) und den während der Ruhezeit gemessenen Spannungswerten, und
- die Bestimmung des Ladungszustands entsprechend dem Indikator mittels einer Eichungskurve, die Schwankungen des Indikators in Abhängigkeit vom Ladungszustand während der Lade- oder Entladungsphase darstellt,

**dadurch gekennzeichnet,**
**dass** der Indikator durch die Formel

$$ind1 = \frac{U_{(l2)} - \alpha}{U_{(l2)} - U_{(l1)}} \times (U_{(l1)} - U_{(l0)})$$

gegeben ist, wobei $U_{(l1)}$ der erste in der Ruhezeit gemessene Spannungswert ist, $U_{(l2)}$ der zweite in der Ruhezeit gemessene Spannungswert ist und $\alpha$ ein Parameter, der vorab während einer Eichungsphase von $\alpha$ in aufeinander folgenden Wiederholungen bestimmt wird, um eine gleichförmige Eichungskurve zu erhalten.

3.  Verfahren nach einem der Ansprüche 1 und 2, **dadurch gekennzeichnet,**
    **dass** die Ruhezeit eine Dauer von weniger als oder gleich 60 Sekunden hat.

**Claims**

1.  A method for determining the state of charge of a battery during a charging or discharging phase of the battery, comprising the following successive steps during said phase:

    - measuring a current I flowing through the battery before being placed in open circuit,
    - placing the battery in open circuit during a rest period (t0-t3),
    - measuring at least first and second values of the voltage at the terminals of the battery at different times (t1, t2) during the rest period (t0-t3),
    - determining an indicator (ind2) according to said current I and to the voltage values measured during the rest period
    - and determining the state of charge corresponding to the indicator by means of a calibration curve representative of the variations of the indicator as a function of the state of charge during the charging or discharging phase

    method **characterized in that** the indicator ind2 is given by the formula $ind2 = \frac{U_{(t2)} - \alpha}{U_{(t2)} - U_{(t1)}} \times I$ with $U_{(t1)}$ the first voltage value measured during the rest period, $U_{(t2)}$ the second voltage value measured during the rest period and $\alpha$ a parameter determined beforehand during a calibration phase by successive iterations of a, to obtain a monotone calibration curve.

2.  A method for determining the state of charge of a battery during a charging or discharging phase of the battery, comprising the following successive steps during said phase:

    - measuring the voltage $U_{(t0)}$ at the battery terminals before being placed in open circuit,
    - placing the battery in open circuit during a rest period (t0-t3),
    - measuring at least first and second values of the voltage at the terminals of the battery at different times (t1, t2) during the rest period (t0-t3),
    - determining an indicator (ind1) according to the voltage $U_{(t0)}$ and to the voltage values measured during the rest period,
    - and determining the state of charge corresponding to the indicator by means of a calibration curve representative of the variations of the indicator as a function of the state of charge during the charging or discharging phase.

    method **characterized in that** the indicator is given by the formula

    $$ind1 = \frac{U_{(t2)} - \alpha}{U_{(t2)} - U_{(t1)}} \times (U_{(t1)} - U_{(t0)})$$ with $U_{(t1)}$

    the first measure of voltage during the rest period, $U_{(t2)}$ the second measure of voltage during the rest period and $\alpha$ a parameter determined beforehand during a calibration phase by successive iterations of a, to obtain a monotone calibration curve,

3.  The method according to claim 1 or 2, **characterized in that** the rest period has a duration less than or equal to 60 seconds.

Figure 1 (Art antérieur)

Figure 2

Figure 3

Figure 4

Figure 5

## RÉFÉRENCES CITÉES DANS LA DESCRIPTION

**Documents brevets cités dans la description**

- EP 0391106 A

- US 2005231206 A

**Littérature non-brevet citée dans la description**

- **SABINE PILLER et al.** Methods for state-of-charge determination and their applications. *journal of power sources,* 2001, 113-120